# EUROPÄISCHE PATENTSCHRIFT

(11) **EP 4 004 793 B1**
(45) Veröffentlichungstag und Bekanntmachung des Hinweises auf die Patenterteilung: **10.09.2025**
(21) Anmeldenummer: 20746605.3
(22) Anmeldetag: 23.07.2020
(51) Int. Cl.: G06F 30/00, G06T 19/00

(54) **FÜNF STUFEN DER BAUBARKEIT**
FIVE STAGES OF CONSTRUCTABILITY
CINQ NIVEAUX DE LA CONSTRUCTIBILITÉ

(30) Priorität: 25.07.2019 DE 102019120165
(43) Veröffentlichungstag der Anmeldung: 01.06.2022
(73) Patentinhaber: VOLKSWAGEN AG, 38440 Wolfsburg (DE)
(72) Erfinder: GREVE, Torsten, 38179 Schwülper (DE); HENSEL, Matthias, 38165 Wolfsburg (DE); WESSEL, Oliver, 38530 Didderse (DE)
(74) Vertreter: Gulde & Partner
(86) Internationale Anmeldenummer: PCT/EP2020/070817
(87) Internationale Veröffentlichungsnummer: WO 2021/013937

(56) Entgegenhaltungen:
- EP-A2- 1 403 790
- US-A1- 2002 123 812
- FUNK MARKUS ET AL: "HoloLens is more than air Tap : natural and intuitive interaction with holograms", PROCEEDINGS OF THE SEVENTH INTERNATIONAL CONFERENCE ON THE INTERNET OF THINGS , IOT '17, 22 October 2017 (2017-10-22), New York, New York, USA, pages 1 - 2, XP093147911, ISBN: 978-1-4503-5318-2
- VIJAIMUKUND RAGHAVAN ET AL: "Interactive Evaluation of Assembly Sequences Using Augmented Reality", IEEE TRANSACTIONS ON ROBOTICS AND AUTOMATION, IEEE INC, NEW YORK, US, vol. 15, no. 3, 1 June 1999 (1999-06-01), XP011053407, ISSN: 1042-296X

## Beschreibung

Die Erfindung betrifft ein Verfahren zur Herstellung eines Produkts gemäß dem Oberbegriff des Patentanspruchs 1 und ein Produkt gemäß dem Oberbegriff des Patentanspruchs 10.

In bekannten Produktentstehungsprozessen kommt es häufig zu einer Abweichung von Herstellungsergebnissen unter Laborbedingungen, beispielsweise in frühen Entwicklungsphasen und Herstellungsergebnissen unter Serienproduktionsbedingungen. Hieraus ergibt sich eine Diskrepanz zwischen Laborbaubarkeit und Serienbaubarkeit neuer Produkte.

Konventionell wird das Problem durch Nacharbeiten gelöst, was einen entsprechend großen Aufwand mit sich bringt.

Der Erfindung liegt die Aufgabe zugrunde, nicht die Auswirkungen der Diskrepanz zwischen Laborbaubarkeit und Serienbaubarkeit zu beheben, sondern diese Diskrepanz selbst in der Produktentstehung zu beseitigen.

Vijaimukund Raghavan et. all., "Interactive Evaluation of Assembly Sequences Using Augmented Reality" IEEE ISN: 1042-296X offenbart ein Verfahren zur Herstellung von Prototypen mithilfe eines mixed prototyping. Es werden virtuelle Prototypen mit realen Prototypen übereinander gelegt, um eine Qualität der realen Prototyps zu überprüfen.

EP 1 403 790 A2 offenbart ein Verfahren zum Aufbau eines Technikträgers mit einer neu entwickelten Fahrzeugkomponente und einer Serienkomponente, wobei ein virtuelles Modell der neuentwickelten Fahrzeugkomponente erzeugt wird und dieses mit der realen Serienkomponente überlagert wird und anschließend auf Abweichungen überprüft wird.

Die Aufgabe wird durch die Gegenstände der unabhängigen Patentansprüche 1 und 10 gelöst. Weitere bevorzugte Ausgestaltungen der Erfindung ergeben sich aus den übrigen, in den Unteransprüchen genannten Merkmalen.

Ein erster Aspekt der Erfindung betrifft ein Verfahren zur Herstellung eines Produkts, umfassend die Schritte:
a) Erzeugung eines interaktiven virtuellen Modells des Produkts als interaktives Hologrammprodukt;
b) Durchführung und Validierung von manuellen Montagevorgängen mit dem virtuellen Modell;
c) Herstellung von Teilen des Produkts unter Einsatz von Rapid-Prototyping und/oder prototypischen Serienwerkzeugen;
d) Durchführung und Validierung von Montagevorgängen mit den hergestellten Teilen; und
e) Iterative Modifikation des virtuellen Modells und/oder der Serienwerkzeuge und Durchlauf der Schritte a) bis d), bis die Montagevorgänge mit den hergestellten Teilen definierte Qualitätsanforderungen erfüllen.

Dies bietet den Vorteil, dass eine Prototypenfertigung unter Serienbedingungen nach Abschluss der Entwicklung entfällt und Diskrepanzen zwischen Laborbaubarkeit und Serienbaubarkeit bereits während der Entwicklung des Produkts und der Werkzeuge vermieden werden. Das Produkt und die verwendeten Werkzeuge können dabei simultan und iterativ aufeinander angepasst werden. Das Verfahren kann ohne Zusatzaufwand und Kosten abgewickelt werden und vermeidet gegenüber konventionellen Verfahren eine Nacharbeit um mehr als 60%.

Die Erstellung von interaktiven virtuellen Modellen, beispielsweise in Virtual-Reality-Umgebunden, ist heutzutage für sich genommen gut bekannt, so dass der zuständige Fachmann in der Lage ist, notwendige technische Systeme für die Schritte a) und b) selbstständig auszuwählen.

In erfindungsgemäßer Ausgestaltung des Verfahrens der Erfindung ist vorgesehen, dass in Schritt a) ein interaktives Hologrammprodukt erzeugt wird.

In weiterhin bevorzugter Ausgestaltung des Verfahrens der Erfindung ist vorgesehen, dass in Schritt a) das interaktive virtuelle Modell des Produkts unter Simulation realer Gravitationsbedingungen erzeugt wird.

Durch die Darstellung unter Gravitationsbedingungen kann die Realität bis auf 98 % Sicherheit dargestellt werden.

In weiterhin erfindungsgemäßer Ausgestaltung des Verfahrens der Erfindung ist vorgesehen, dass in Schritt b) manuelle Montagevorgänge an dem interaktiven virtuellen Modell des Produkts durchgeführt werden.

Mit anderen Worten kann ein Werker seine ersten Schraub- und Montierversuche an dem Modell absolvieren.

In weiterhin bevorzugter Ausgestaltung des Verfahrens der Erfindung ist vorgesehen, dass in Schritt c) ein 3D-Druckverfahren eingesetzt wird.

In weiterhin bevorzugter Ausgestaltung des Verfahrens der Erfindung ist vorgesehen, dass in Schritt c) ein Laserimprovisationsverfahren eingesetzt wird.

Der Einsatz von Rapid-Prototyping bietet sich aufgrund der höheren Toleranzen insbesondere für die Herstellung von Teilen mit nur geringer Qualitätsrelevanz an.

Manche Teile können aber auch nicht mit Rapid-Prototyping hergestellt werden. Diese werden unter Nutzung von Techniken wie dem Einsatz prototypischer Serienwerkzeuge hergestellt, die dann problemorientiert angepasst werden.

So ist in weiterhin bevorzugter Ausgestaltung des Verfahrens der Erfindung vorgesehen, dass in Schritt c) ein prototypisches Serienwerkzeug eingesetzt wird, das gegenüber einem Serienwerkzeug eine reduzierte Komplexität aufweist.

Beispielsweise können bei einem Umformwerkzeug nur Formflächen für eine Makrostruktur des herzustellenden Teils des Produkts vorgesehen sein, um damit zunächst die Baubarkeit des Teils hinsichtlich seiner Einbaumaße zu testen. Formflächen für eine Mikrostruktur des Teils können dem Werkzeug dann hinzugefügt werden, wenn beispielsweise in Schritt e) eine Iterative Verbesserung erfolgt.

In weiterhin bevorzugter Ausgestaltung des Verfahrens der Erfindung ist vorgesehen, dass es sich bei dem Produkt um ein Fahrzeug handelt.

In weiterhin bevorzugter Ausgestaltung des Verfahrens der Erfindung ist vorgesehen, dass in Schritt c) ein Karosserieteil des Fahrzeugs mit einem prototypischen Serienwerkzeug hergestellt wird.

Das Karosserieteil kann zum Beispiel eine Außenhaut oder ein Strukturteil sein.

In weiterhin bevorzugter Ausgestaltung des Verfahrens der Erfindung ist vorgesehen, dass in Schritt c) ein Interieurteil eines Fahrzeugs unter Einsatz von Rapid-Prototyping hergestellt wird.

In weiterhin bevorzugter Ausgestaltung des Verfahrens der Erfindung ist vorgesehen, dass in Schritt d) zumindest teilweise ein Fahrzeug montiert wird.

Ein weiterer Aspekt der Erfindung betrifft ein Produkt, hergestellt in einem erfindungsgemäßen Verfahren gemäß der vorhergehenden Beschreibung.

In bevorzugter Ausgestaltung des Produkts der Erfindung ist vorgesehen, dass es sich um ein Fahrzeug handelt.

Die verschiedenen in dieser Anmeldung genannten Ausführungsformen der Erfindung sind, sofern im Einzelfall nicht anders ausgeführt, mit Vorteil miteinander kombinierbar.

Die Erfindung wird nachfolgend in einem Ausführungsbeispiel anhand der zugehörigen Zeichnung erläutert.

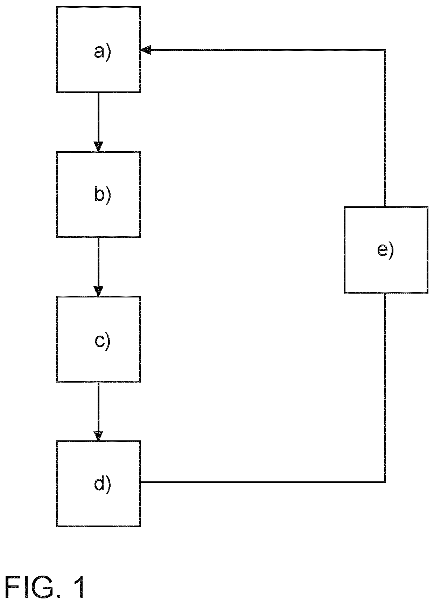

- Figur 1: zeigt ein Blockschema des Ablaufs eines erfindungsgemäßen Verfahrens zur Herstellung eines Produkts.

In einem ersten Schritt a) erfolgt zunächst eine Erzeugung eines interaktiven virtuellen Modells des Produkts. Dabei handelt es sich in diesem Ausführungsbeispiel um ein interaktives Hologrammprodukt, das unter Simulation realer Gravitationsbedingungen erzeugt wird, wobei entsprechende technische Systeme im Bereich der virtuellen Realität zum Einsatz kommen.

In einem zweiten Schritt b) erfolgt eine Durchführung und Validierung von Montagevorgängen mit dem virtuellen Modell. In diesem Ausführungsbeispiel werden manuelle Montagevorgänge an dem interaktiven virtuellen Modell des Produkts durchgeführt.

In einem dritten Schritt c) erfolgt eine Herstellung von Teilen des Produkts unter Einsatz von Rapid-Prototyping und/oder prototypischen Serienwerkzeugen. In diesem Ausführungsbeispiel werden sowohl Teile von geringer Qualitätsrelevanz in einem 3D-Druckverfahren und einem Laserimprovisationsverfahren hergestellt als auch Teile mit hoher Qualitätsrelevanz mit einem prototypischen Serienwerkzeug hergestellt.

Das prototypische Serienwerkzeug ist gegenüber einem tatsächlichen Serienwerkzeug in seiner Komplexität reduziert. Exemplarisch handelt es sich bei dem Produkt, dessen Teile hergestellt werden, um ein Fahrzeug. Dabei werden Karosserieteile des Fahrzeugs mit dem prototypischen Serienwerkzeug hergestellt und Interieurteile des Fahrzeugs unter Einsatz des Rapid-Prototyping-Verfahrens.

In einem vierten Schritt d) erfolgt eine Durchführung und Validierung von Montagevorgängen mit den hergestellten Teilen.

Dabei wird ein sogenanntes B-Auto aufgebaut, das einem wenigstens teilweise montierten Fahrzeug entspricht und das auf Einhaltung der Qualitätsanforderungen geprüft wird. Die Qualitätsanforderungen umfassen beispielsweise Spaltmaße und andere bekannte Anforderungen und werden entsprechend nicht vollständig erfüllt, wenn das vorgegebene Maß am B-Auto nicht eingehalten wird.

In einem fünften Schritt e) erfolgt nun eine iterative Modifikation des virtuellen Modells und der Serienwerkzeuge, um die Ursachen für die Maßabweichungen zu beheben. Dabei kann die Ursache sowohl in der Gestaltung des Produkts liegen, als auch in jener des Werkzeugs. Das Produkt und das Werkzeug werden daher gleichsam weiterentwickelt.

Basierend darauf erfolgt erneut der Durchlauf der Schritte a) bis d), bis die Montagevorgänge mit den hergestellten Teilen den definierten Qualitätsanforderungen entsprechen.

## Patentansprüche

1. Verfahren zur Herstellung eines Produkts, umfassend die Schritte:
a) Erzeugung eines interaktiven virtuellen Modells des Produkts als interaktives Hologrammprodukt unter Einsatz technischer Systeme im Bereich der virtuellen Realität unter Simulation realer Gravitationsbedingungen;
b) Durchführung und Validierung von manuellen Montagevorgängen mit dem virtuellen Modell, indem die manuellen Montagevorgänge an dem interaktiven virtuellen Modell des Produkts durchgeführt werden und ein Werker seine ersten Schraub- und Montierversuche an dem Modell absolviert;
c) Herstellung von Teilen des Produkts unter Einsatz von Rapid-Prototyping und/oder prototypischen Serienwerkzeugen;
d) Durchführung und Validierung von Montagevorgängen mit den hergestellten Teilen;
und
e) Iterative Modifikation des virtuellen Modells und/oder der Serienwerkzeuge und Durchlauf der Schritte a) bis d), bis die Montagevorgänge mit den hergestellten Teilen definierte Qualitätsanforderungen erfüllen.

2. Verfahren nach Anspruch1, **dadurch gekennzeichnet, dass** in Schritt a) das interaktive virtuelle Modell des Produkts unter Simulation realer Gravitationsbedingungen erzeugt wird.

3. Verfahren nach einem der vorhergehenden Ansprüche, **dadurch gekennzeichnet, dass** in Schritt c) ein 3D-Druckverfahren eingesetzt wird.

4. Verfahren nach einem der vorhergehenden Ansprüche, **dadurch gekennzeichnet, dass** in Schritt c) ein Laserimprovisationsverfahren eingesetzt wird.

5. Verfahren nach einem der vorhergehenden Ansprüche, **dadurch gekennzeichnet, dass** in Schritt c) ein prototypisches Serienwerkzeug eingesetzt wird, das gegenüber einem Serienwerkzeug eine reduzierte Komplexität aufweist.

6. Verfahren nach einem der vorhergehenden Ansprüche, **dadurch gekennzeichnet, dass** es sich bei dem Produkt um ein Fahrzeug handelt.

7. Verfahren nach Anspruch 6, **dadurch gekennzeichnet, dass** in Schritt c) ein Karosserieteil des Fahrzeugs mit einem prototypischen Serienwerkzeug hergestellt wird.

8. Verfahren nach Anspruch 6 oder 7, **dadurch gekennzeichnet, dass** in Schritt c) ein Interieurteil eines Fahrzeugs unter Einsatz von Rapid-Prototyping hergestellt wird.

9. Verfahren nach einem der Ansprüche 6 bis 8, **dadurch gekennzeichnet, dass** in Schritt d) zumindest teilweise ein Fahrzeug montiert wird.

10. Produkt, hergestellt in einem Verfahren nach einem der Ansprüche 1 bis 9.

11. Produkt nach Anspruch 10, **dadurch gekennzeichnet, dass** es sich um ein Fahrzeug handelt.

## Claims

1. Method for manufacturing a product, comprising the steps of:
a) generating an interactive virtual model of the product as an interactive hologram product using technical systems in the field of virtual reality, with simulation of real gravitational conditions;
b) carrying out and validating manual assembly processes using the virtual model by carrying out the manual assembly processes on the interactive virtual model of the product and having a worker complete their first screwing and assembly attempts on the model;
c) manufacturing parts of the product using rapid prototyping and/or prototype series-production tools;
d) carrying out and validating assembly processes using the manufactured parts; and
e) iteratively modifying the virtual model and/or the series-production tools and executing steps a) to d) until the assembly processes using the manufactured parts meet defined quality requirements.

2. Method according to claim 1, **characterized in that** the interactive virtual model of the product is generated with simulation of real gravitational conditions in step a).

3. Method according to either of the preceding claims,
**characterized in that** a 3D printing process is used in step c).

4. Method according to any of the preceding claims, **characterized in that** a laser improvisation process is used in step c).

5. Method according to any of the preceding claims, **characterized in that** a prototype series-production tool which has a reduced complexity compared to a series-production tool is used in step c).

6. Method according to any of the preceding claims, **characterized in that** the product is a vehicle.

7. Method according to claim 6, **characterized in that** a body part of the vehicle is manufactured using a prototype series-production tool in step c).

8. Method according to claim 6 or claim 7, **characterized in that** an interior part of a vehicle is manufactured using rapid prototyping in step c).

9. Method according to any of claims 6 to 8, **characterized in that** a vehicle is at least partially assembled in step d).

10. Product manufactured in a method according to any of claims 1 to 9.

11. Product according to claim 10, **characterized in that** it is a vehicle.

## Revendications

1. Procédé pour la fabrication d'un produit, comprenant les étapes consistant à :
a) créer un modèle virtuel interactif du produit sous la forme d'un hologramme de produit interactif en utilisant des systèmes techniques du domaine de la réalité de synthèse en simulant des conditions gravitationnelles réelles ;
b) réaliser et valider des processus d'assemblage manuel avec le modèle virtuel en réalisant les processus d'assemblage manuel sur le modèle virtuel interactif du produit et en permettant à un ouvrier de réaliser ses premiers essais de vissage et d'assemblage sur le modèle ;
c) fabriquer des parties du produit en utilisant le prototypage rapide et/ou des outils de production en série pour prototypage ;
d) réaliser et valider des processus d'assemblage avec les pièces fabriquées ; et
e) modifier par itération le modèle virtuel et/ou les outils de production en série et passer par les étapes a) à d) jusqu'à ce que les processus d'assemblage avec les pièces fabriquées répondent à des exigences de qualité définies.

2. Procédé selon la revendication 1, **caractérisé en ce que,** à l'étape a), le modèle virtuel interactif du produit est généré en simulant des conditions gravitationnelles réelles.

3. Procédé selon l'une des revendications précédentes,
**caractérisé en ce qu'**un procédé d'impression 3D est utilisé à l'étape c).

4. Procédé selon l'une des revendications précédentes,
**caractérisé en ce qu'**un procédé d'improvisation au laser est utilisé à l'étape c).

5. Procédé selon l'une des revendications précédentes, **caractérisé en ce qu'**à l'étape c), un outil de production en série pour prototypage qui présente une complexité réduite par rapport à un outil de production en série est utilisé.

6. Procédé selon l'une des revendications précédentes,
**caractérisé en ce que** le produit est un véhicule.

7. Procédé selon la revendication 6, **caractérisé en ce qu'**à l'étape c), une pièce de carrosserie du véhicule est fabriquée avec un outil de production en série pour prototypage.

8. Procédé selon la revendication 6 ou 7, **caractérisé en ce qu'**à l'étape c), une pièce d'intérieur d'un véhicule est fabriquée en utilisant un prototypage rapide.

9. Procédé selon l'une des revendications 6 à 8, **caractérisé en ce qu'**à l'étape d), un véhicule est assemblé au moins partiellement.

10. Produit, fabriqué lors d'un procédé selon l'une des revendications 1 à 9.

11. Produit selon la revendication 10, **caractérisé en ce qu'**il s'agit d'un véhicule.
